# EUROPÄISCHE PATENTSCHRIFT

(11) **EP 1 102 392 B1**
(45) Veröffentlichungstag und Bekanntmachung des Hinweises auf die Patenterteilung: **24.03.2004**
(21) Anmeldenummer: 00125507.4
(22) Anmeldetag: 21.11.2000
(51) Int. Cl.: H03D 3/00, H03C 3/40, H03C 3/09

(54) **Quadraturmodulator**
Quadrature Modulator
Modulateur en quadrature

(30) Priorität: 22.11.1999 DE 19956073
(43) Veröffentlichungstag der Anmeldung: 23.05.2001
(73) Patentinhaber: Infineon Technologies AG, 81669 München (DE)
(72) Erfinder: Simon, Martin, 83624 Otterfing (DE); Veit, Werner, 82008 Unterhaching (DE)
(74) Vertreter: Epping, Hermann, Fischer

(56) Entgegenhaltungen:
- US-A- 5 953 641
- IRVINE G ET AL: "An up-conversion loop transmitter IC for digital mobile telephones" SOLID-STATE CIRCUITS CONFERENCE, 1998. DIGEST OF TECHNICAL PAPERS. 1998 IEEE INTERNATIONAL SAN FRANCISCO, CA, USA 5-7 FEB. 1998, NEW YORK, NY, USA,IEEE, US, 5. Februar 1998 (1998-02-05), Seiten 364-365,465, XP010278638 ISBN: 0-7803-4344-1
- FURUSKAER A ET AL: "EDGE: ENHANCED DATA RATES FOR GSM AND TDMA/136 EVOLUTION" IEEE PERSONAL COMMUNICATIONS, IEEE COMMUNICATIONS SOCIETY, US, Bd. 6, Nr. 3, Juni 1999 (1999-06), Seiten 56-66, XP000831521 ISSN: 1070-9916
- YAMAWAKI T ET AL: "A 2.7-V GSM RF TRANSCEIVER IC" IEEE JOURNAL OF SOLID-STATE CIRCUITS, IEEE INC. NEW YORK, US, Bd. 32, Nr. 12, 1. Dezember 1997 (1997-12-01), Seiten 2089-2096, XP000767457 ISSN: 0018-9200

## Beschreibung

Die Erfindung betrifft eine Schaltungsanordnung zur Modulation mit einer Sende-PLL. Solche Modulatoren sind insbesondere zur GMSK-Modulation in Mobilfunkgeräten geeignet.

In Mobilfunkgeräten nach dem GSM-Standard erfolgt die Datenübertragung unter Anwendung der GMSK-Modulation. Dieselbe Modulationsart wird derzeit sowohl zur Sprachübertragung als auch zur Übertragung von Daten verwendet. Die Datenrate ist allerdings für über den reinen Sprachdienst hinausgehende Multimediaanwendungen nicht ausreichend, so daß ein neuerer Standard eine 8-PSK-Modulation vorsieht. Mit 8-PSK-Modulation kann die dreifache Datenmenge pro Zeiteinheit übertragen werden. Die GMSK-Symbole haben eine konstante Hüllkurve, d.h. eine konstante Amplitude, während die 8-PSK-Symbole eine nicht konstante Hüllkurve haben und unterschiedliche Amplitude aufweisen. Gemäß der Spezifikation des Standards kann zwischen GMSK- und 8-PSK-Modulation von einem Zeitschlitz zum nächsten Zeitschlitz unmittelbar umgeschaltet werden. Das kombinierte Übertragungssystem wird GSM-Edge genannt.

Für die GMSK-Modulation wird eine Sende-PLL (PLL: Phase Lokked Loop) oder Upconversion Loop verwendet. In der Literaturstelle G. Irvine et al.: "An Up-conversion Loop Transmitter IC for Digital Mobile Telephones, 1998 IEEE International Solid-State Circuits Conference, S. 364 - 365, ist eine Sende-PLL gezeigt. Ein spannungsgesteuerter Oszillator (VCO) wird mit der Phaseninformation angesteuert und erzeugt das modulierte Ausgangssignal zur Abstrahlung über die Antenne nach geeigneter Verstärkung. Der Ausgang des VCO wird über einen Abwärtsmischer, dem das Ausgangssignal eines Kanaloszillators zugeführt wird, und einen Quadraturkomponentenmodulator auf einen Phasendetektor des Phasenregelkreises rückgekoppelt. Im Phasendetektor wird das abwärts modulierte Signal mit einer Referenzfrequenz verglichen. Das Ausgangssignal des Phasendetektors wird über ein Schleifenfilter geführt, um das Frequenzsteuersignal für den VCO zu erzeugen. Der Quadraturkomponentenmodulator wird bei Irvine at al. vom abwärts gemischten Ausgangssignal angesteuert. In der Literaturstelle Yamawaki et al.: "A 2,7-V GSM RF Transceiver IC", IEEE Journal of Solid-State Circuits, Band 32, Nr. 12, Dezember 1997, S. 2089 - 2096 ist eine Sende-PLL beschrieben, bei der der Ausgang des Abwärtsmischers unmoduliert auf einen Eingang des Phasendetektors rückgekoppelt wird und der andere Eingang des Phasendetektors von einem Oszillator, dem die Quadraturkomponenten des Nutzsignals aufmoduliert sind, gespeist wird. Der Quadraturkomponentenmodulator liegt vor dem Phasendiskriminator entweder in der Rückkopplungsschleife der Sende-PLL (Irvine et al.) oder im Referenzsignalpfad (Yamawaki et al.)

Das Schleifenfilter der Sende-PLL ist ein Tiefpaß und wirkt hochfrequenzmäßig innerhalb der Sende-PLL als schmalbandiger Bandpaß, um das Nutzsignal passieren zu lassen. Der VCO ist rauscharm ausgeführt. Diese Lösung hat sich besonders deshalb durchgesetzt, weil auf ein Duplexfilter nach dem Sendeverstärker und unmittelbar vor der Antenne verzichtet werden kann. Das Duplexfilter sorgt für eine Dämpfung des Sendesignals außerhalb des Sendebands und verhindert die Einstreuung von Rauschen und Nebenaussendungen in den Empfangskanal. Es ist relativ teuer und erfordert einen erhöhten Stromverbrauch im Sendeverstärker.

Wegen dieser Vorteile ist es wünschenswert, das Konzept der Sende-PLL auch in Geräten gemäß dem kombinierten GMSK-/8-PSK-Standard weiter zu verwenden. Da die Amplitude des Ausgangssignals des VCO bei der GMSK-Modulation konstant ist, eine 8-PSK-Modulation demgegenüber aber amplitudenvariable Einhüllende hat, kann eine Sende-PLL für eine 8-PSK-Modulation ohne weiteres nicht verwendet werden.

Die Aufgabe der Erfindung besteht darin, eine Schaltungsanordnung zur Modulation anzugeben, die für zwei Modulationsarten, insbesondere GMSK- und 8-PSK-Modulation geeignet ist.

Gelöst wird diese Aufgabe durch eine Schaltungsanordnung zur Modulation, die umfaßt: einen ersten Modulator mit einem frequenzsteuerbaren Oszillator, der einen Ausgang für ein erstes Ausgangssignal aufweist; einem Phasendetektor, wobei der Ausgang des Oszillators über einen Abwärtsmischer auf den Phasendetektor rückgekoppelt ist, und einer Mischeranordnung, um ein mit einem Nutzsignal moduliertes Signal bereitzustellen; einen zweiten Modulator, der eingangsseitig mit dem Ausgang des Oszillators verbunden ist und der eine Mischeranordnung umfaßt, um ein mit dem Nutzsignal moduliertes Signal als zweites Ausgangssignal bereitzustellen; eine erste Umschalteinrichtung, um zwischen dem ersten und dem zweiten Ausgangssignal umzuschalten und eine zweite Umschalteinrichtung, um an einem Eingangsanschluß des Phasendetektors ein nicht moduliertes Signal bereitzustellen, wenn die erste Umschalteinrichtung auf das zweite Ausgangssignal umgeschaltet ist, und um am Eingangsanschluß des Phasendetektors das vom Nutzsignal modulierte Signal bereitzustellen, wenn die erste Umschalteinrichtung auf das erste Ausgangssignal umgeschaltet ist.

Bei der Schaltungsanordnung gemäß der Erfindung wird für die GMSK-Modulation weiterhin eine Sende-PLL verwendet und die damit einhergehenden Vorteile bleiben erhalten. Wenn 8-PSK-Modulation gefordert wird, schaltet die Anordnung auf einen Direktmodulator um. Als Oszillator für die Trägerfrequenz des Direktmodulators wird der VCO der Sende-PLL verwendet. Hierzu wird der Quadraturkomponentenmodulator in der Sende-PLL wirkungslos geschaltet. Die Anordnung gemäß der Erfindung kombiniert daher Prinzipien der Sende-PLL und der Direktmodulation, wobei besonders aufwendige Komponenten gemeinsam benutzt werden.

Für die 8-PSK-Modulation sieht die Standardisierung wegen einer geringeren spezifischen Sendeleistung niedrigere Rauschanforderungen an den Sendepfad vor. Im Abstand von 10 MHz und 20 MHz vom Sendeträger ist das Signal-Rausch-Verhältnis entsprechend zur Sendeleistung um 6 dB niedriger als bei der GMSK-Modulation. Für die GMSK-Modulation muß nach dem Leistungsverstärker gefiltert werden, da das Rauschen im Sendeband durch den nichtlinearen Verstärker in das Empfängerband gefaltet wird (Noise Conversion Gain). Bei Benutzung eines linearen Verstärkers für die 8-PSK tritt dieser Effekt nur sehr schwach auf. Es genügt daher, am Ausgang des Direktmodulators und vor dem Sendeverstärker ein Oberflächenwellenfilter vorzusehen, um ein Aussenden in den Empfangskanal zu vermeiden. Ein Duplexfilter, das bei der Verwendung eines Direktmodulators für GMSK-Modulation erforderlich gewesen wäre, ist nicht mehr notwendig, um die Anforderungen der GSM-Edge-Norm an Übersprechdämpfung bei 8-PSK-Modulation einzuhalten. Der GSMK-Pfad kommt ohne Duplexfilter aus, so daß sich die Sprechzeit des Mobilfunkgeräts erhöht.

Die Verwendung des VCOs der Sende-PLL als Synthesizers für den Direktmodulator stellt für den Direktmodulator ein rauscharmes Eingangssignal zur Verfügung. Der schnell regelnde Synthesizer mit dem relativ breiten Schleifenfilter sorgt dafür, daß Load-Pulling-Effekte, die im Vergleich zu herkömmlichen Kanalsynthesizern auf Endfrequenz auftreten können, bei der Anordnung gemäß der Erfindung vermieden werden.

Zweckmäßigerweise wird bei 8-PSK-Betrieb der VCO der Sende-PLL in einem Stromsparmodus betrieben, so daß die verfügbare Sprechzeit des Mobilfunkgeräts weiter erhöht wird.

Zur Umschaltung zwischen Sende-PLL und Direktmodulator sind verschiedene alternative Konzepte möglich. Zweckmäßigerweise wird der Quadraturkomponentenmodulator der Sende-PLL bei 8-PSK-Betrieb mit konstanten Quadratursignalkomponenten angesteuert, so daß effektiv keine Modulation erfolgt. Der zusätzliche Aufwand zur Realisierung der Schaltungsanordnung nach der Erfindung besteht dann in einem weiteren integrierten Schaltkreis, der die Komponenten der Direktmodulationsanordnung enthält. Diese Schaltung ist kompatibel mit bisherigen integrierten Schaltungen für die Sende-PLL kombinierbar. Durch einfaches Hinzufügen der integrierten Schaltung für den Direktmodulator können bisherige Schaltungsarchitekturen weiter verwendet werden, um GMSK-fähige Mobiltelefone für kombinierten GMSK-/8-PSK-Betrieb weiter zu entwickeln. Alternativ kann der Quadraturkomponentenmodulator in der Sende-PLL bei 8-PSK-Betrieb durch einen Bypass umgangen werden. Zweckmäßigerweise wird der Modulator dann abgeschaltet, so daß Stromverbrauch gespart wird. Dieses Konzept erfordert jedoch ein Redesign der integrierten Schaltung für die Sende-PLL.

Die Endstufenverstärker für die Sende-PLL arbeiten bekanntlich nichtlinear mit Begrenzerkennlinie, da die GMSK-Symbole eine konstante Hüllkurve oder Amplitude haben. Die Sendeendstufe für den Direktmodulator im 8-PSK-Betrieb erfordert einen Verstärker mit linearer Übertragungskennlinie, da die Hüllkurve der 8-PSK-Symbole oder deren Amplitude nicht konstant veränderlich ist. Die Zusammenfassung der Sendepfade von Sende-PLL und Direktmodulator kann einerseits nach den Sendeverstärkern erfolgen, wobei für die Sende-PLL eine nichtlineare Verstärkerstufe vorzusehen ist, für den Direktmodulator eine linear arbeitende Verstärkerstufe. Die Zusammenfassung der Sendepfade kann andererseits vor der Leistungsendstufe erfolgen, wobei der Verstärker bezüglich seines Arbeitspunkts umschaltbar auszuführen ist, so daß nichtlinearer und linearer Verstärkerbetrieb von einer einzigen Verstärkerstufe abhängig von der jeweiligen Modulationsart ausführbar sind.

Durch die Sendearchitektur gemäß der Erfindung ist es möglich, sowohl für GMSK- als auch für 8-PSK-Betrieb eine hinsichtlich Leistungsverbrauch und Herstellungskosten optimierte Lösung zu realisieren. Eine Kompatibilität zu bisherigen integrierten Sende-PLL-Schaltungen kann gewährleistet werden. Es ergibt sich eine effektive Doppelnutzung von Komponenten. Das System kann problemlos auf Dual-Band-Mobilfunkgeräte, die sowohl dem GSM-Standard als auch den PCN-Standard genügen, erweitert werden.

Nachfolgend wird die Erfindung anhand der in der Zeichnung dargestellten Figuren näher erläutert. Entsprechende Elemente sind mit gleichen Bezugszeichen versehen. Es zeigen:
- Figur 1: ein erstes Ausführungsbeispiel für eine Anordnung zur umschaltbaren GMSK-/8-PSK-Modulation und
- Figur 2: ein zweites Ausführungsbeispiel für eine solche Anordnung.

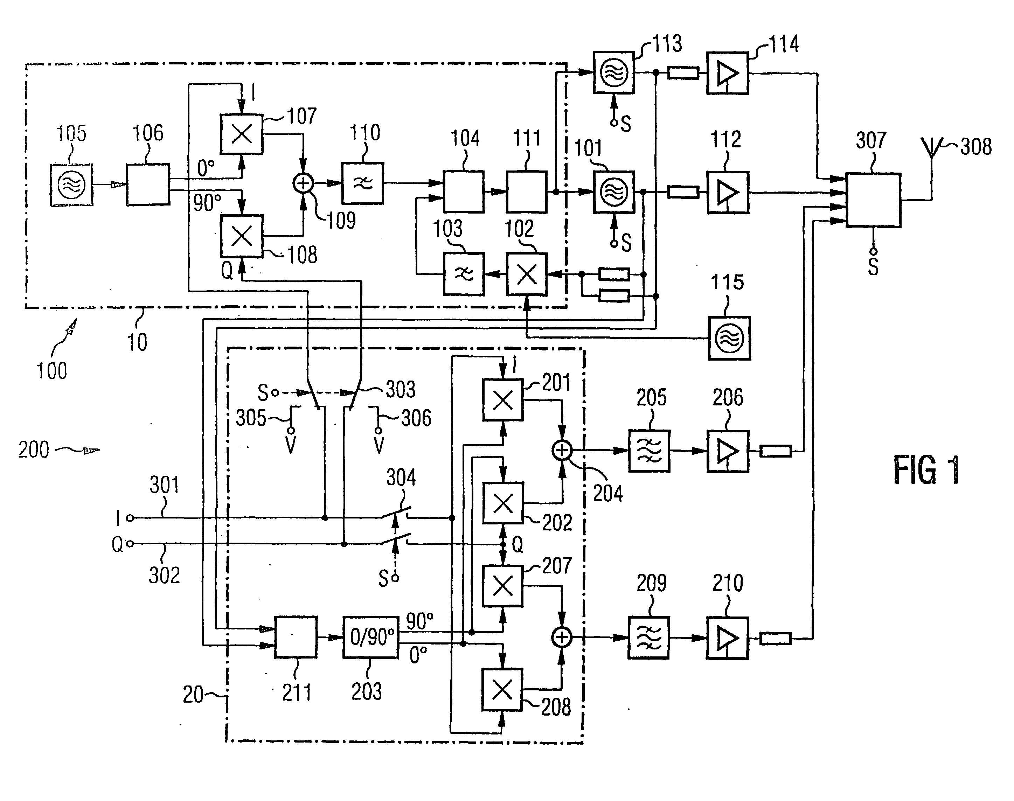

Die Anordnung in Figur 1 zeigt eine herkömmliche Sende-PLL (Upconversion Loop) 100 sowie eine Direktmodulationsanordnung 200 unter Benutzung eines gemeinsamen Oszillators. Die Sende-PLL 100 umfaßt einen spannungssteuerbaren Oszillator (VCO) 101, dessen Ausgangssignal bei GMSK-Betrieb GMSK-moduliert ist. Der Oszillator wird über einen Abwärtsmischer 102 mit nachgeschaltetem Tiefpaß 103 auf einen Phasendetektor oder Phasendiskriminator 104 rückgekoppelt. Dem Abwärtsmischer 102 wird die von einem weiteren VCO 115 erzeugte Frequenz des Sendekanals zugeführt, so daß das Ausgangssignal des Sende-VCO 101 auf verschiedene Kanäle des verfügbaren GSM-Frequenzbands abstimmbar ist. Der andere Eingang des Phasendetektors 104 wird von einem Oszillator 105 gespeist, dessen Ausgangssignal zuerst über einen Teiler 106 durch 4 geführt wird, der um 0°/90° verschobene Quadraturkomponenten erzeugt. Diese werden in den jeweiligen Quadraturkomponenten zugeordneten Mischern 107 bzw. 108 mit den Quadraturkomponenten I, Q eines Nutzsignals moduliert. Die modulierten Signale werden in einem Summierer 109 addiert und über einen Tiefpaß 110 an den Referenzeingang des Phasendetektors 104 weitergeleitet. Das an diesem Eingang des Phasendetektors 104 anliegende modulierte Signal wird mit dem über den Pfad 102, ..., 104 rückgekoppelten Sendesignal verglichen. Die Phasendifferenz wird über ein Schleifenfilter 111 geführt und als Frequenzsteuerinformation in den Sende-VCO 101 eingespeist. Das Schleifenfilter 111 hat Tiefpaßcharakteristik und läßt das Frequenzband des Nutzsignals durch, so daß der VCO 101 entsprechend dem Sendesignal I, Q in der Phase nachgestellt wird. Am Ausgang des VCO 101 liegt dann das GMSK-modulierte Sendesignal an.

Für eine 8-PSK-Modulation weist der Direktmodulator 200 einen Quadraturkomponentenmischer 201, 202 auf, dem die Nutzsignalkomponenten I, Q zugeführt werden. Außerdem werden den Mischern 201, 202 um 90° zueinander phasenverschobene Trägersignale zugeführt. Hierzu wird die Trägerfrequenz am Ausgang des VCO 101 der Sende-PLL abgegriffen und in einem Phasenschieber 203 in Quadraturkomponenten aufgespaltet. Ein Summierglied 204 addiert die modulierten Quadraturkomponenten an den Ausgängen der Mischer 201, 202 zum 8-PSK-modulierten Ausgangssignal des Direktmodulators.

Die Quadraturkomponenten I, Q des Nutzignals werden an Anschlüssen 301, 302 eingespeist. Ein Umschalter 303 verbindet die Anschlüsse 301, 302 mit den Signaleingängen der Mischer 107, 108 der Sende-PLL während des GMSK-Betriebs. Ein Schalter 304 dient zur Verbindung der Anschlüsse 301, 302 mit den Nutzsingaleingängen der Mischer 201, 202 während des 8-PSK-Betriebs. Die Schalter 303, 304 werden wechselseitig geschaltet. Bei geschlossenem Schalter 304 für 8-PSK-Betrieb wird der Schalter 303 auf Anschlüsse 305, 306 umgelegt, an denen ein Konstantsignal V eingespeist wird. Dies bedeutet, daß die Signaleingänge der Mischer 107, 108 mit einem konstanten Signal beaufschlagt werden, so daß eine Nutzsignalmodulation nicht stattfindet. Das Konstantsignal V muß hierzu so groß gewählt werden, daß die Mischer 107, 108 als reine Verstärker arbeiten. Der VCO 101 der Sende-PLL stellt in diesem Fall ein nicht moduliertes Trägersignal für den Direktmodulator 200 bereit.

Für sämtliche Signale ist eine einzige Leitung dargestellt; es versteht sich, daß in der praktischen Realisierung bestimmte Signale, insbesondere die Signalkomponenten I, Q, als gegenphasige, differenzielle Signale vorliegen und auf entsprechenden Leitungen geführt werden.

Um eine Einkopplung der vom Direktmodulator erzeugten unerwünschten Seitenbänder in den Empfangskanal zu vermeiden, ist an den Ausgang des Summierglieds 204 ein Oberflächenwellenfilter (OFW) 105 angeschlossen. Das Oberflächenwellenfilter wirkt als steilwandiger Bandpaß, der außerhalb des Sendebands liegende Signalanteile mit hoher Dämpfung unterdrückt. Die Dämpfung des OFW-Filter reicht aus, um die Spezifikationen des Standards für den 8-PSK-Betrieb einzuhalten. Gegenüber GMSK ist die Sendeleistung bei 8-PSK um 6 dB niedriger, so daß ein OFW-Filter ausreichend ist. Das OFW-Filter ist relativ kostengünstig und liefert trotzdem eine ausreichende Dämpfung.

Das modulierte Ausgangssignal des VCO 101 wird durch einen Sendeverstärker 112 verstärkt. Der Verstärker 112 hat eine nichtlineare Kennlinie und wird in Begrenzerbetrieb verwendet, da das GMSK-Signal eine konstante Hüllkurve hat. Dem OFW-Filter 205 ist als Sendeverstärker ein linearer Verstärker 206 nachgeschaltet, so daß die sich symbolweise verändernde Amplitudeninformation eines 8-PSK-Signals nach Verstärkung erhalten bleibt. Die Ausgänge beider Verstärker 112, 206 werden an einen Umschalter 307 gelegt, der je nach Betriebsanforderung zwischen GMSK- oder 8-PSK-moduliertem Ausgangssignal umschaltet. Das Sendesignal wird über eine Antenne 308 abgestrahlt.

Die beschriebene Schaltung eignet sich allgemein für eine zwischen GMSK und PSK umschaltbare Modulation bei jeglicher Frequenz. Die Schaltung kann daher durch entsprechend parallel geführte Zweige sowohl für den Mobilfunkstandard GSM 900 als auch für den Mobilfunkstandard DCS 1800 oder PCN weitergebildet werden. Die bisher beschriebenen Komponenten sind für GSM 900 dimensioniert. Für das PCN-Frequenzband ist parallel zum VCO 101 ein VCO 113 mit nachgeschaltetem Verstärker 114 vorgesehen. Parallel zum Direktmodulator 201, 202 ist für das PCN-Frequenzband ein Quadraturkomponentenmodulator 207, 208 vorgesehen sowie ausgangsseitig ein entsprechendes OFW-Filter 209 und ein zugeordneter Verstärker 210. Die Signalpfade werden im Umschalter 307 zusammengeführt. Ein Multiplexer 211 sorgt am Eingang des Phasenschiebers 203 für eine Umschaltung zwischen den VCOs 101 und 113. Die beschrieben Schaltung eignet sich zur Herstellung eines Dual-Band-Mobilfunkgeräts mit GSM-Edge-Fähigkeit.

Bei der in Figur 1 gezeigten Schaltung sind die mit 10 umrandeten Elemente in einem integrierten Schaltkreis zusammengefaßt. Die sendeseitigen VCOs sowie die Verstärker und der VCO 115 für die Kanalfrequenzen sind chipextern realisiert. Die integrierte Schaltung 10 ist als herkömmliches Bauelement für eine Sende-PLL für GMSK-Modulation verfügbar. Die mit 20 umrandeten Komponenten des Direktmodulators können in einem weiteren integrierten Schaltkreis hergestellt werden. Dabei ist die Schaltung 20 anschlußkompatibel zur bereits bekannten Schaltung 10. Ein GMSK-/8-PSK-fähiges Mobilfunkgerät kann daher unter Verwendung der bisherigen Schaltungsarchitektur für ein nur GMSK-fähiges Mobilfunkgerät entwickelt werden, indem im wesentlichen nur die integrierte Schaltung 20 sowie die Komponenten 205, 206, 209, 210 sowie 307 hinzugefügt werden.

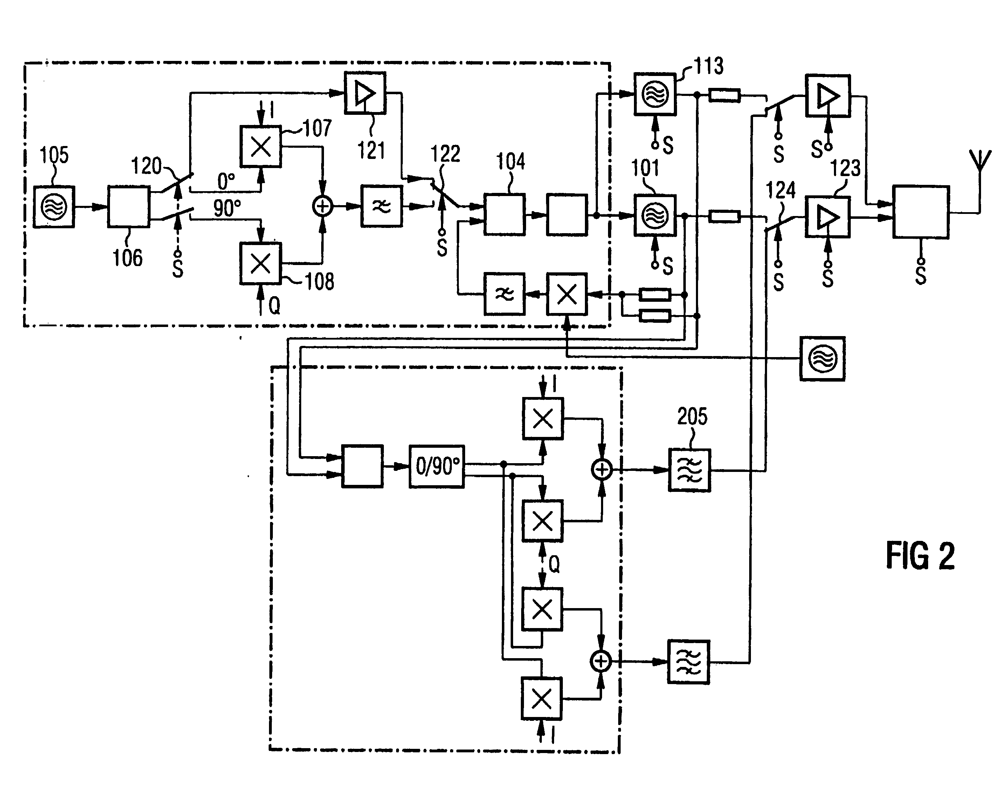

Bei der Ausführung nach Figur 2 wird bei 8-PSK-Betrieb der Quadraturkomponentenmodulator 107, 108 über einen Bypass umgangen. Hierzu ist am Ausgang des Teilers 106 ein Umschalter 120 vorgesehen, der bei GSM-Betrieb die vom Oszillator 105 erzeugte Trägerfrequenz auf den Modulator 107, 108 weiterschaltet, bei 8-PSK-Betrieb hingegen über einen Verstärker 121 führt. Am Eingang des Phasendiskriminators 104 sorgt ein Schalter 122 für eine entsprechende Umschaltung des Signalpfads. Diese Lösung hat den Vorteil, daß die Mischer 107, 108 bei 8-PSK-Betrieb abgeschaltet werden können. Dadurch wird Verlustleistung gespart, die Batterien des Mobilfunkgeräts werden geschont und die verfügbare Sprechzeit des Geräts wird verlängert. Im Vergleich zur Ausführung in Figur 1 sind Schalter 303, 304 nicht mehr erforderlich.

Anstelle der in Figur 1 für jeden Signalpfad vorgesehenen Endstufenverstärker weist die Schaltung in Figur 2 für GMSKund 8-PSK-Betrieb kombinierte Leistungsendstufen auf (jeweils für GSM- und PCN-Standard getrennt). Der Verstärker 123 ist sowohl für Begrenzerbetrieb während der GMSK-Modulation als auch für linearen Verstärkerbetrieb während der 8-PSK-Modulation umschaltbar und eingangsseitig über einen Schalter 124 sowohl mit dem Ausgang des VCO 101 als auch dem Ausgang des OFW-Filters 205 verbunden. Das Platinenlayout, sowie der Verdrahtungsaufwand und die Leitungsführung der Hochfrequenzsignale werden vereinfacht.

Zweckmäßigerweise sind die VCOs 101, 113 bezüglich ihrer Treiberfähigkeit und somit Verlustleistung umschaltbar ausgeführt. Bei GMSK-Betrieb werden die VCOs 101, 113 bei hoher Leistungsaufnahme betrieben, um ein Signal mit entsprechend ausreichender Treiberfähigkeit für die Verstärker 112 bzw. 114 bereit zu stellen. Für 8-PSK-Betrieb hingegen genügt es, die VCOs 101, 113 mit niedriger Treiberfähigkeit und daher entsprechend geringerem Leistungsverbrauch zu betreiben, da die Mischer 201, 202 bzw. 207, 208 ausreichend Treiberleistung für die zugeordneten Endstufen 206 bzw. 210 bereitstellen. Die Batteriekapazität und verfügbare Sendezeit bei 8-PSK-Betrieb wird dadurch wiederum erhöht.

Die Umschaltung zwischen den Modulationsarten GMSK und 8-PSK wird durch ein Schaltsignal S gesteuert. Das Signal S wird den Schaltern, den Verstärkern und den Oszillatoren, die bezüglich Linearitätsverhalten bzw. Treiberleistung schaltbar sind, zugeführt.

Im übrigen ist es alternativ zu den dargestellten Ausführungen möglich, den Quadraturkomponentenmodulator 106, ..., 110 für die GMSK-Modulation im Rückkopplungspfad der Sende-PLL anzuordnen. In diesem Fall ist das Phasenglied 106 gegebenenfalls ohne Frequenzteilung an den Ausgang des Filters 103 anzuschließen. Der Ausgang des Filters 110 wird in den Phasendetektor 104 rückgekoppelt. Der Oszillator 105 wird gegebenenfalls unter Zwischenschaltung eines Teilers direkt, d.h. ohne Modulator, an den anderen Anschluß des Phasendetektors 104 angeschlossen.

Durch die beschriebene Schaltungsanordnung wird die Herstellung eines Mobilfunkgeräts für Mulimediaanwendungen gemäß dem GSM-Edge-Standard mit geringem Kostenaufwand ermöglicht. Die Vorteile bei der Verwendung einer Sende-PLL (Upconversion Loop) bleiben erhalten. Der zusätzliche Aufwand wird durch die Doppelnutzung aufwendiger Komponenten gering gehalten. Bei geeigneter Ausführung kann Kompatibilität zu bisherigen Architekturen sichergestellt werden.

## Patentansprüche

1. Schaltungsanordnung zur Modulation, die umfaßt:
- einen ersten Modulator (100) mit
- einem frequenzsteuerbaren Oszillator (101, 113), der einen Ausgang für ein erstes Ausgangssignal aufweist,
- einem Phasendetektor (104), wobei der Ausgang des Oszillators (101, 113) über einen Abwärtsmischer (102) auf den Phasendetektor (104) rückgekoppelt ist und
- einer Mischeranordnung (107, 108, 109), um ein mit einem Nutzsignal moduliertes Signal bereitzustellen,
**dadurch gekennzeichnet, dass** die Schaltungsanordung folgende Elemente aufweist :
- einen zweiten Modulator (200),
- der eingangsseitig mit dem Ausgang des Oszillators (101, 113) verbunden ist und
- der eine Mischeranordnung (201, 202, 204, 207, 208) umfaßt, um ein mit dem Nutzsignal moduliertes Signal als zweites Ausgangssignal bereitzustellen,
- eine erste Umschalteinrichtung (307), um zwischen dem ersten und dem zweiten Ausgangssignal umzuschalten und
- eine zweite Umschalteinrichtung (303, 120, 122), um an einem Eingangsanschluß des Phasendetektors (104) ein nicht moduliertes Signal bereitzustellen, wenn die.erste Umschalteinrichtung (307) auf das zweite Ausgangssignal umgeschaltet ist, und um am Eingangsanschluß des Phasendetektors (104) das vom Nutzsignal modulierte Signal bereitzustellen, wenn die erste Umschalteinrichtung (307) auf das erste Ausgangssignal umgeschaltet ist.

2. Schaltungsanordnung nach Anspruch 1,
**dadurch gekennzeichnet, daß**
Anschlüsse (301, 302) zur Eingabe von Quadraturkomponenten (I, Q) des Nutzsignals vorgesehen sind und eine Schalteinrichtung (304) und Anschlüsse (305, 306) für ein Konstantsignal (V), daß
- die Schalteinrichtung (304) derart ausgebildet ist, daß das Nutzsignal der Mischeranordnung (201, 202, 204, 207, 208) des zweiten Modulators (200) zuführbar ist und daß die zweite Umschalteinrichtung (303) derart ausgebildet ist, daß das Konstantsignal (V) der zweiten Mischeranordnung (200) zuführbar ist, wenn die erste Umschalteinrichtung (307) auf das zweite Ausgangssignal umgeschaltet ist, und daß
- die zweite Umschalteinrichtung (303) derart ausgebildet ist, daß das Nutzsignal der Mischeranordnung (107, 108, 109) des ersten Modulators (100) zuführbar ist, wenn die erste Umschalteinrichtung (307) auf das erste Ausgangssignal umgeschaltet ist.

3. Schaltungsanordnung nach Anspruch 1,
**dadurch gekennzeichnet, daß**
die zweite Umschalteinrichtung (120, 122) derart ausgebildet ist, daß
- die Mischeranordnung (107, 108, 109) des ersten Modulators (100) eingangsseitig mit einem weiteren Oszillator (105) gekoppelt ist und ausgangsseitig mit dem Eingangsanschluß des Phasendetektors (104), wenn die erste Umschalteinrichtung (307) auf das erste Ausgangssignal umgeschaltet ist, und daß
- der Eingangsanschluß des Phasendetektors (104) mit dem weiteren Oszillator (105) unter Umgehung der Mischeranordnung (107, 108, 109) des ersten Modulators (100) gekoppelt ist, wenn die erste Umschalteinrichtung (307) auf das zweite Ausgangssignal umgeschaltet ist.

4. Schaltungsanordnung nach einem der Ansprüche 1 bis 3,
**gekennzeichnet durch**
einen nichtlinearen Verstärker (112, 114), über den das erste Ausgangssignal an die erste Umschalteinrichtung (307) koppelbar ist, und einen linearen Verstärker (206, 210), **durch** den das zweite Ausgangssignal an die erste Umschalteinrichtung (307) koppelbar ist.

5. Schaltungsanordnung nach einem der Ansprüche 1 bis 3,
**gekennzeichnet durch**
einen Verstärker (123), der zwischen einer ersten Betriebsart mit nichtlinearem Verstärkerbetrieb und einer zweiten Betriebsart mit linearem Verstärkerbetrieb umschaltbar ist, und
einen Schalter (124), über den dem Verstärker (123) eingangsseitig das erste oder das zweite Ausgangssignal zuführbar ist.

6. Schaltungsanordnung nach einem der Ansprüche 1 bis 5,
**gekennzeichnet durch**
ein Oberflächenwellenfilter (205, 209), das dem Ausgang der Mischereinrichtung (201, 202, 204, 207, 208) des zweiten Modulators (200) nachgeschaltet ist.

7. Schaltungsanordnung nach Anspruch 1 oder 2,
**dadurch gekennzeichnet, daß**
die Mischeranordnung (107, 108, 109) des ersten Modulators (100) eingangsseitig mit dem Abwärtsmischer (102) gekoppelt ist.

8. Schaltungsanordnung nach einem der Ansprüche 1 bis 7,
**dadurch gekennzeichnet, daß**
der Oszillator (101, 113) eine Betriebsart mit hoher Treiberfähigkeit und eine Betriebsart mit niedrigerer Treiberfähigkeit hat und daß die zweite Betriebart einstellbar ist, wenn die erste Umschalteinrichtung (307) auf das zweite Ausgangssignal umgeschaltet ist.

9. Schaltungsanordnung nach einem der Ansprüche 1 bis 8,
**dadurch gekennzeichnet, daß**
das Nutzsignal in Form von Quadraturkomponenten (I, Q) zuführbar ist und die Modulatoren jeweils aufweisen:
- ein Phasenglied (106, 203) zur Aufspaltung eines Trägersignals in um 90° zueinander phasenverschobene Signalkomponenten,
- zwei Mischer (107, 201, 207; 108, 202, 208), denen jeweils eine der Signalkomponenten und eine der Quadraturkomponenten zuführbar ist, und
- ein Summierglied (109, 204) zur Addition von Ausgangssignalen der Mischer.

## Claims

1. Circuit arrangement for modulation which comprises:
- a first modulator (100) having
- a frequency-controlled oscillator (101, 113) which has an output for a first output signal,
- a phase detector (104), with the output of the oscillator (101, 113) being fed back to the phase detector (104) via a down-converter (102), and
- a mixer arrangement (107, 108, 109) for providing a signal modulated by a useful signal,
**characterized in that** the circuit arrangement has the following elements:
- a second modulator (200),
- whose input side is connected to the output of the oscillator (101, 113), and
- which comprises a mixer arrangement (201, 202, 204, 207, 208) for providing a signal modulated by the useful signal as a second output signal,
- a first changeover device (307) for changing over between the first and second output signals, and
- a second changeover device (303, 120, 122) for providing an unmodulated signal on an input connection on the phase detector (104) when the first changeover device (307) has been changed over to the second output signal, and for providing the signal modulated by the useful signal on the input connection of the phase detector (104) when the first changeover device (307) has been changed over to the first output signal.

2. Circuit arrangement according to Claim 1,
**characterized in that**
connections (301, 302) for inputting quadrature components (I, Q) of the useful signal are provided and a switching device (304) and connections (305, 306) for a constant signal (V), **in that**
- the switching device (304) is in a form such that the useful signal can be supplied to the mixer arrangement (201, 202, 204, 207, 208) in the second modulator (200) and **in that** the second changeover device (303) is in a form such that the constant signal (V) can be supplied to the second mixer arrangement (200) when the first changeover device (307) has been changed over to the second output signal, and **in that**
- the second changeover device (303) is in a form such that the useful signal can be supplied to the mixer arrangement (107, 108, 109) in the first modulator (100) when the first changeover device (307) has been changed over to the first output signal.

3. Circuit arrangement according to Claim 1,
**characterized in that**
the second changeover device (120, 122) is in a form such that
- the mixer arrangement (107, 108, 109) in the first modulator (100) is coupled to a further oscillator (105) on the input side and to the input connection of the phase detector (104) on the output side when the first changeover device (307) has been changed over to the first output signal, and that
- the input connection of the phase detector (104) is coupled to the further oscillator (105) by means of a bypass around the mixer arrangement (107, 108, 109) in the first modulator (100) when the first changeover device (307) has been changed over to the second output signal.

4. Circuit arrangement according to one of Claims 1 to 3,
**characterized by**
a non-linear amplifier (112, 114) via which the first output signal can be coupled to the first changeover device (307), and a linear amplifier (206, 210) which can couple the second output signal to the first changeover device (307).

5. Circuit arrangement according to one of Claims 1 to 3,
**characterized by**
an amplifier (123) which can be changed over between a first mode of operation with non-linear amplifier operation and a second mode of operation with linear amplifier operation, and a switch (124) which can be used to supply the first or the second output signal to the input side of the amplifier (123).

6. Circuit arrangement according to one of Claims 1 to 5,
**characterized by**
a surface acoustic wave filter (205, 209) which is connected downstream of the output of the mixer device (201, 202, 204, 207, 208) in the second modulator (200).

7. Circuit arrangement according to Claim 1 or 2,
**characterized in that**
the input side of the mixer arrangement (107, 108, 109) in the first modulator (100) is coupled to the down-converter (102).

8. Circuit arrangement according to one of Claims 1 to 7,
**characterized in that**
the oscillator (101, 113) has a mode of operation with a high driver capability and a mode of operation with a lower driver capability, and **in that** the second mode of operation can be set when the first changeover device (307) has been changed over to the second output signal.

9. Circuit arrangement according to one of Claims 1 to 8,
**characterized in that**
the useful signal can be supplied in the form of quadrature components (I, Q), and the modulators each have:
- a phase element (106, 203) for splitting a carrier signal into signal components which are phase-shifted through 90° with respect to one another,
- two mixers (107, 201, 207; 108, 202, 208) which can each have one of the signal components and one of the quadrature components supplied to them, and
- a summation element (109, 204) for adding output signals from the mixers.

## Revendications

1. Circuit de modulation, qui comprend
- un premier modulateur (100) avec
- un oscillateur commandable en fréquence (101, 113) qui comporte une sortie pour un premier signal de sortie,
- un détecteur de phase (104), la sortie de l'oscillateur (101, 113) étant branchée en rétroaction via un mélangeur-abaisseur (102) sur le détecteur de phase (104), et
- un mélangeur (107, 108, 109) pour fournir un signal modulé avec un signal utile,
**caractérisé par le fait que** le circuit comporte les éléments suivants :
- un deuxième modulateur (200),
- qui est relié en entrée à la sortie de l'oscillateur (101, 113), et
- qui comprend un mélangeur (201, 202, 204, 207, 208) pour fournir comme deuxième signal de sortie un signal modulé avec le signal utile,
- un premier commutateur (307) pour commuter entre le premier signal de sortie et le deuxième signal de sortie, et
- un deuxième commutateur (303, 120, 122) pour fournir à une borne d'entrée du détecteur de phase (104) un signal non modulé lorsque le premier commutateur (307) est commuté sur le deuxième signal de sortie et pour fournir à la borne d'entrée du détecteur de phase (104) le signal modulé par le signal utile lorsque le premier commutateur (307) est commuté sur le premier signal de sortie.

2. Circuit selon la revendication 1,
**caractérisé par le fait qu'**il est prévu des bornes (301, 302) pour l'entrée de composantes en quadrature (I, Q) du signal utile et un commutateur (304) et des bornes (305, 306) pour un signal constant (V),
- le commutateur (304) est conçu de telle sorte que le signal utile peut être envoyé au mélangeur (201, 202, 204, 207, 208) du deuxième modulateur (200) et le deuxième commutateur (303) est conçu de telle sorte que le signal constant (V) peut être envoyé au deuxième mélangeur (200) lorsque le premier commutateur (307) est commuté sur le deuxième signal de sortie, et
- le deuxième commutateur (303) est conçu de telle sorte que le signal utile peut être envoyé au mélangeur (107, 108, 109) du premier modulateur (100) lorsque le premier commutateur (307) est commuté sur le premier signal de sortie.

3. Circuit selon la revendication 1,
**caractérisé par le fait que** le deuxième commutateur (120, 122) est conçu de telle sorte que
- le mélangeur (107, 108, 109) du premier modulateur (100) est relié en entrée à un autre oscillateur (105) et en sortie à la borne d'entrée du détecteur de phase (104) lorsque le premier commutateur (307) est commuté sur le premier signal de sortie, et
- la borne d'entrée du détecteur de phase (104) est reliée à l'autre oscillateur (105) en contournant le mélangeur (107, 108, 109) du premier modulateur (100) lorsque le premier commutateur (307) est commuté sur le deuxième signal de sortie.

4. Circuit selon l'une des revendications 1 à 3,
**caractérisé par** un amplificateur non linéaire (112, 114), par l'intermédiaire duquel le premier signal de sortie peut être envoyé au premier commutateur (307), et par un amplificateur linéaire (206, 210), par l'intermédiaire duquel le deuxième signal de sortie peut être envoyé au premier commutateur (307).

5. Circuit selon l'une des revendications 1 à 3,
**caractérisé par** un amplificateur (123), qui est commutable entre un premier mode de fonctionnement avec amplification non linéaire et un deuxième mode de fonctionnement avec amplification linéaire, et par un commutateur (124), par l'intermédiaire duquel le premier ou le deuxième signal de sortie peut être envoyé en entrée à l'amplificateur (123).

6. Circuit selon l'une des revendications 1 à 5,
**caractérisé par** un filtre à ondes de surface (205, 209) qui est branché du côté aval de la sortie du mélangeur (201, 202, 204, 207, 208) du deuxième modulateur (200).

7. Circuit selon la revendication 1 ou 2,
**caractérisé par le fait que** le mélangeur (107, 108, 109) du premier modulateur (100) est relié en entrée au mélangeur-abaisseur (102).

8. Circuit selon l'une des revendications 1 à 7,
**caractérisé par le fait que** l'oscillateur (101, 113) présente un mode de fonctionnement avec possibilité d'attaque élevée et un mode de fonctionnement avec possibilité d'attaque réduite et le deuxième mode de fonctionnement est réglable lorsque le premier commutateur (307) est commuté sur le deuxième signal de sortie.

9. Circuit selon l'une des revendications 1 à 8,
**caractérisé par le fait que** le signal utile peut être envoyé sous forme de composantes en quadrature (I, Q) et que les modulateurs comportent à chaque fois :
- un élément déphaseur (106, 203) pour la décomposition d'un signal porteur en composantes de signal déphasées de 90° l'une par rapport à l'autre,
- deux mélangeurs (107, 201, 207 ; 108, 202, 208) auxquels peuvent être envoyées à chaque fois l'une des composantes de signal et l'une des composantes en quadrature, et
- un élément additionneur (109, 204) pour additionner des signaux de sortie des mélangeurs.
